## Europäisches Patentamt
## European Patent Office
## Office européen des brevets

(11) Publication number: **0 040 488**
**A1**

# (12) EUROPEAN PATENT APPLICATION

(21) Application number: 81301979.1

(22) Date of filing: 06.05.81

(51) Int. Cl.³: **B 22 D 11/06**
**C 30 B 15/00, H 01 L 31/18**

(30) Priority: 15.05.80 US 150257
30.06.80 US 164403

(43) Date of publication of application:
25.11.81 Bulletin 81/47

(84) Designated Contracting States:
DE FR GB

(71) Applicant: International Business Machines Corporation

Armonk, N.Y. 10504(US)

(72) Inventor: Chaudhari, Praveen
416 Long Hill Road East
Briarcliff Manor New York 10510(US)

(72) Inventor: Lacey, James Andrew
Mountainview Drive
Mahopac New York 10541(US)

(72) Inventor: Mueller, Rene
Buchhaldenstrasse 2
CH-5442 Fislisbach(CH)

(74) Representative: Petersen, Richard Courtenay
IBM United Kingdom Patent Operations Hursley Park
Winchester Hants. SO21 2JN(GB)

(54) Method of fabricating a ribbon structure.

(57) In a method of fabricating a layered ribbon structure (24), metal, such as copper, iron, iron alloy or silver, is melted in a crucible (4) by an RF heater (8) and ejected through a nozzle (10) by inert gas supplied under pressure through a pipe (18) and regulated by a valve (22). The stream of molten metal from the nozzle is directed at a small angle to the vertical upon the crest of a rotating wheel (14) to generate a moving ribbon (11). A dissimilar material of lower melting point, such as a semiconductor material, silicon, germanium or gallium arsenide, is melted in a second crucible (2) by an RF heater (6) and ejected through a nozzle (12) by inert gas supplied under pressure through a pipe (16) and regulated by a valve (20).

The stream of molten semiconductor material is directed parallel to the stream of molten metal upon the moving ribbon of metal to generate a ribbon (13) which forms a second layer of layered ribbon structure (24). The method may be used for the mass production of semiconductor devices such as diodes, solar cells and the like.

METHOD OF FABRICATING A RIBBON STRUCTURE


This invention relates to methods of fabricating ribbon structures, which comprise discharging material in a molten state under pressure onto the cylindrical surface of a rotating cylinder to form a moving ribbon of the material.

It has been reported that equipment classically employed to produce amorphous alloy ribbons can be used to generate polycrystalline ribbons of silicon which can be employed for solar cells. The crystalline silicon ribbons so produced are deposited in an evacuated chamber and have a small grain size. N Tsuya and K I Arai, report in Solid State Physics (in Japanese) 13, 237 (1978), an average grain size of several microns. They have reported the results for the same operating conditions in J Applied Phys., 18, 207 (1979), where the grain size is reported as 2 to 3 microns.

These small grains are substantially smaller than those which should be employed to maintain a reasonable efficiency in any resulting solar cell. In order to obtain an efficiency of approximately 10% it would be required that the grain size be increased by an order of magnitude to approximately 10 to 30 microns.

Dropwise deposition of a semiconductor liquid into a contoured mould to generate homogeneous bodies has been proposed in US 3,367,394. US 4,124,411 describes a dropwise technique to form on a substrate a layer of a semiconductor material. While the latter technique allows the production of layers of semiconductors suitable for solar cells the generation of these layers is slow and an appropriate substrate must be prepared.

It is an object of the present invention to provide a method of producing layered ribbons of dissimilar materials.

The present invention provides a process for fabricating layered materials in the form of a ribbon. The materials can be semiconductors or metal/semiconductor combinations. Briefly, this process is performed by using two jets to impinge a first molten material upon a spinning wheel and sequentially depositing a second molten material onto the first deposited material strip or ribbon. While the present invention will hereinafter be described using two jets to provide a two layered ribbon structure, it will be appreciated that more than two jets may be used to provide multilayered ribbon structures.

The concept of forming a ribbon of a material by impinging molten material onto a rotating wheel is known, but generally required a vacuum system to effect the desired material and/or produced amorphous materials. Nowhere is it suggested that the sequential deposition of differing materials would provide layered ribbons from which semiconductor devices can be fabricated.

Moreover, layered devices are commonly formed by the more conventional techniques such as vacuum evaporation, e-beam evaporation, RF sputtering, CVD etc. These techniques are limited by their own individual drawbacks. The amount of material prepared is also limited in output per given run. The method of the present invention has the further advantages of enabling the production of substantial volumes of multilayered materials, the production of an entire device in one step and the production of crystalline semiconductor materials having large grain size.

0040488

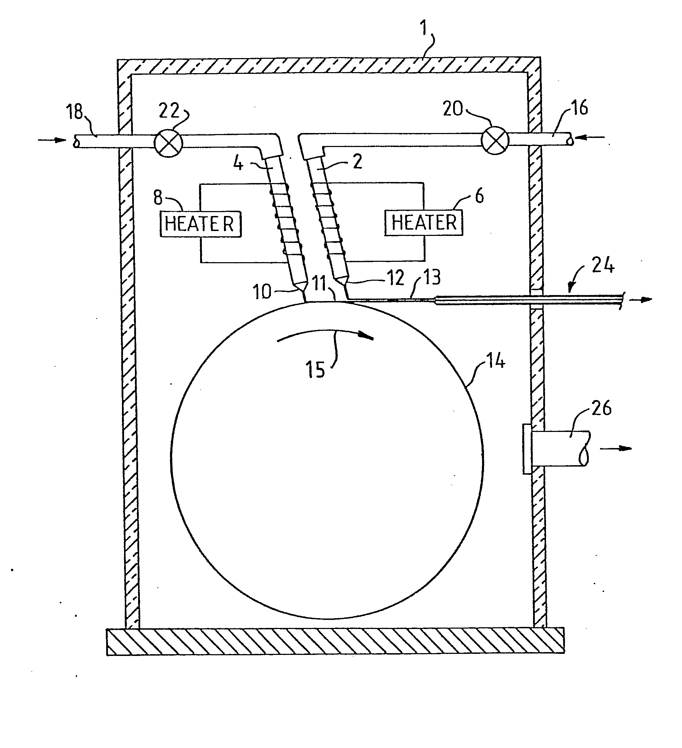

The scope of the invention is defined by the appended claims; and how it can be carried into effect is hereinafter particularly described with reference to the acocmpanying drawings, in which the only figure is a schematic representation of an apparatus suitable for carrying out the method according to the present invention.

Apparatus suitable for carrying out the method according to the present invention is housed in a gas chamber 1. A port 26 is provided in chamber 1 for release of gas or if desired to connect the chamber 1 to a vacuum source to create a vacuum therein.

A cylindrical wheel 14 is rotatably mounted in the chamber 1 and connected to be driven by a motor (not shown) at between 1,000 and 10,000 RPM and preferably between 2,000 and 6,000 RPM. The wheel is of a thermally conducting material, such as copper or stainless steel, and has a cylindrical surface of 76.2 mm diameter to give approximate linear velocities of 4 to 40 m/s and 8 to 24 m/s, respectively. Precise wheel speeds may vary with the material being deposited and can be determined readily.

A tubular crucible 4 is mounted above the wheel 14 with its central axis directed towards the crest of the wheel and at an angle of 10° to 15° to an extended radial line through the crest and away from the direction 15 of rotation of the wheel. The crucible 4 has a nozzle 10 of between 0.5 and 1.5 mm width and preferably about 1 mm and is preferably no more than 3 mm above the crest of the wheel 14. The crucible 4 is for containing a supply of material for forming the first layer of a layered ribbon structure. The material is maintained in a molten state by RF induction heater 8. The material in the crucible 4 is subject to gas pressure supplied through a supply tube 16 and controlled by a regulator valve 22. The valve 22 is adjusted to give an injection pressure of between 7 and 210 kPa (1 and 30 psig) and preferably between 28 and 104 kPa (4 and 15 psig), which is applied to the material by the gas which is an inert gas, such as helium or argon.

The injection pressure discharges molten material from the crucible 4 through the nozzle 10 to impinge on the cylindrical surface of the rotating wheel 14 just in advance of the crest. As the molten material impinges on the surface of the wheel a ribbon 11 of the material is generated and, subject to centrifugal force due to the rotation of the wheel, leaves the surface at the crest and is withdrawn from the chamber 1 at the same linear velocity as the linear velocity of the surface of the wheel.

A second tubular crucible 2 is mounted adjacent and parallel to the crucible 4 and has a similar nozzle 12. The axes of the crucibles 2 and 4 are separated by approximately 10 mm, on either side of an axis pointing directly at the crest of the wheel. The nozzle 12 is preferably no more than 3 mm above the crest. The crucible 2 is for containing a supply of a material to form a second layer of the layered ribbon structure, which material is dissimilar to, and has a melting point lower than that of, the material in the crucible 4.

The material in the crucible 2 is maintained in a molten state by an RF induction heater 6 and is subject to gas pressure supplied through a supply tube 18 and controlled by a regulator valve 20. An injection pressure of between 7 and

                                                    **0040488**

210 kPa (1 and 30 psig) and preferably between 28 and 104 kPa
(4 to 15 psig) is maintained on the material by adjustment of
the valve. The gas is an inert gas, such as helium or argon.

The injection pressure discharges molten material from
the crucible 2 through the nozzle 12 to impinge on the moving
ribbon 11 of material from the crucible 4 just beyond the
crest and to generate a ribbon 13 thereon forming the second
layer of a layered ribbon structure 24.

Preferably, the material for crucible 4 is a metal
selected from copper, iron, iron alloys and silver. The
material for crucible 2 is preferably a semiconductor
material selected from silicon, germanium and gallium
arsenide. However, a variety of combination of materials can
be used provided the criterion of the difference in melting
points of the materials is satisfied.

RF heating of semiconductor material is accomplished by
using a graphite sleeve (not shown) around the crucible to
form a furnace because semiconductor materials do not readily
couple directly to the RF.

The following examples are by way of illustration only:

                          Example 1


                           Ge on Cu



The crucibles 2 and 4 containing Ge and Cu,
respectively, were heated to temperatures of 940°C and 1085°C, respectively.  The resulting molten materials were
caused to stream from the crucibles by flowing Ar into the
crucibles to create pressures in the range of from 28 to 104
kPa (4 to 15 psig).  The molten copper was streamed onto a
rotating wheel rotating at speeds of 2,000 RPM, 4,500 RPM and
6,000 RPM during 3 separate runs to form a ribbon 11 onto
which the molten germanium was subsequently streamed to form
the ribbon 13.  Each run produced a layered ribbon 24 of Ge
on Cu.

Example 2

Si on FeSi

The crucibles 2 and 4 containing Si and FeSi alloys,
respectively, were heated to temperatures of approximately
1430°C and 1475°C, respectively.  The proportions of the FeSi
alloys were adjusted to obtain a melting point close to but
slightly higher than the melting point of Si.  Thus, in the
FeSi alloy the silicon content was adjusted to be close to
either 10 or 45 atomic percent.  The latter composition has
the advantage that the Si layer deposited on top further
raises the melting point of the alloy so that the component
structure is more stable relative to melting and
interdiffusion.  The remaining conditions of deposition were
similar to those disclosed in Example 1.

It is necessary that the difference in the melting
points of the materials used is such that the material first being deposited has a higher melting point than the second.
This is to prevent the second material from melting through
the first layer.  Good control of the melting temperatures is
essential at the time of ejection of the materials.  If
control of temperatures is not carefully performed alloying
of the materials may be effected.

As the stream of material from the nozzle 10 emerges, it
has a component of velocity in the direction of a tangent to
the surface of the rotating wheel at the point of impact in
the direction of rotation.  Similarly, the stream of material
from the nozzle 12 emerges with a component of velocity in
the direction of movement of the ribbon 11 leaving the wheel.

When the ribbon is generated in air and a copper wheel
is used, it may be advisable to gold plate the cylindrical
surface to avoid oxidation.

To obtain a large grain size in a semiconductor material
layer of the ribbon, a linear velocity not greater than 36
m/s, and preferably between 8 and 24 m/s, should be used.

It will be appreciated that whilst air or vacuum may be
used within the chamber 1, an inert gas, such as argon or
helium may be used to avoid oxidation.

The present invention can be used in the semiconductor
industry where large scale production of devices is desired.
For example, using the present invention large ribbons of
diodes are readily prepared.  The ribbons need only be diced
to obtain individual diodes.

CLAIMS

1    A method of fabricating a ribbon structure, comprising
discharging material in a molten state under pressure onto
the cylindrical surface of a rotating cylinder (14) to form a
moving ribbon (11) of the material, characterised in that the
ribbon structure is made layered by discharging dissimilar
material in a molten state under pressure onto the surface of
the moving first-formed ribbon (11), the dissimilar material
having a lower melting point than the material of the
first-formed ribbon, to form a layered ribbon structure (24).

2    A method according to claim 1, in which the material of
the first-formed ribbon is metal.

3    A method according to claim 2, in which the metal is
selected from iron, iron alloys, copper and silver.

4    A method according to claim 3, in which the metal
selected is an FeSi alloy.

5    A method according to any preceding claim, in which the
dissimilar material is a semiconductor material.

6    A method according to claim 5, in which the
semiconductor is selected from germanium, silicon and gallium
arsenide.

7    A method according to claim 6 as appendant to claim 3, in which the material of the first-formed ribbon is copper and the dissimilar material is germanium.

8    A method according to claim 6 as appendant to claim 4, in which the dissimilar material is silicon.

9    A method according to any preceding claim, in which an injection pressure of between 28 and 104 kPa (4 and 15 psig) is applied to the material.

10    A method according to claim 9, in which the material is discharged through a nozzle of between 0.5 and 1.5 mm.

11    A method according to claim 10, in which the nozzle is not more than 3 mm from the surface of the wheel.

12    A method according to any preceding claim, in which the linear velocity of the surface of the wheel upon which the material impinges is not greater than 36 m/s.

13    A method according to claim 12, in which the linear velocity is between 8 and 24 m/s.

14    A method according to any preceding claim, in which the method is carried out in a chamber (1).

15    A method according to any preceding claim, in which the method is carried out in air.

16    A method according to any preceding claim, in which the discharge of the material of the first-formed ribbon is directed at a position just in advance of the crest of the wheel.

**0040488**

Application number

# EUROPEAN SEARCH REPORT

European Patent Office

EP 81 30 1979.1

| DOCUMENTS CONSIDERED TO·BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | US – A – 2 847 737 (J.B. BRENNAN)<br>* claim; column 4, lines 44 to 68, fig. 5, 6 *<br>——<br>US – A – 3 421 571 (C.E. WEBBER et al.)<br>* claim 1; fig. 2 *<br>—— | 1–3<br><br><br>1,2 | B 22 D  11/06<br>C 30 B  15/00<br>H 01 L  31/18 |
| A | DE – A1 – 2 830 522 (LICENTIA PATENT-VERWALTUNGS-GMBH)<br>* claims 1, 2; fig. 2 *<br>—— | | **TECHNICAL FIELDS SEARCHED (Int. Cl.³)** |
| P | DE – A1 – 3 017 016 (AGENCE NATIONALE DE VALORISATION DE LA RECHERCHE)<br>* claim 1 *<br>———— | | B 22 D  11/00<br>C 30 B  15/00<br>H 01 L  31/18 |

**CATEGORY OF CITED DOCUMENTS**

X: particularly relevant
A: technological background
O: non-written disclosure  .
P: intermediate document
T: theory or principle underlying the invention
E: conflicting application
D: document cited in the application
L: citation for other reasons
&: member of the same patent family, corresponding document

The present search report has been drawn up for all claims

| Place of search | Date of completion of the search | Examiner |
|---|---|---|
| Berlin | 20-08-1981 | ROTHER |

EPO Form 1503.1  06.78